Europäisches Patentamt

European Patent Office

Office européen des brevets

(19)

(11) Veröffentlichungsnummer : **0 076 228 B1**

(12) **EUROPÄISCHE PATENTSCHRIFT**

(45) Veröffentlichungstag der Patentschrift :
22.01.86

(21) Anmeldenummer : 82710043.9

(22) Anmeldetag : 08.09.82

(51) Int. Cl.⁴ : **G 01 R 33/032, G 01 R 15/07,
G 02 F 1/17**

(54) Faseroptische Messanordnung.

(30) Priorität : 15.09.81 SE 8105473

(43) Veröffentlichungstag der Anmeldung :
06.04.83 Patentblatt 83/14

(45) Bekanntmachung des Hinweises auf die Patenterteilung : 22.01.86 Patentblatt 86/04

(84) Benannte Vertragsstaaten :
CH DE FR GB LI

(56) Entgegenhaltungen :
DE-A- 3 019 030
DE-B- 2 303 078
MEASUREMENT TECHNIQUES, Band 23, Nr. 5 Mai
1980, New York E.N. ZHURAVLEV et al. "Application
of the Keldysh-Franz effect in high tension measurement techniques" Seiten 443 bis 445
OPTICAL ENGINEERING, Band 17, Nr. 5 September-
Oktober 1978 N. BOTTKA "Materials and their properties as they apply to electroabsorptive devices"
Seiten 530 bis 538

(73) Patentinhaber : **ASEA AB**
S-721 83 Västeras (SE)

(72) Erfinder : **Brogardh, Torgny**
**Platverksgatan 140**
S-724 74 Västeras (SE)
Erfinder : **Ovrén, Christer, Dr.**
**Vilddjursvägen 9**
S-722 43 Västeras (SE)

(74) Vertreter : **Boecker, Joachim, Dr.-Ing.**
**Rathenauplatz 2-8**
D-6000 Frankfurt a.M. 1 (DE)

**Beschreibung**

Die Erfindung betrifft eine faseroptische Meßanordnung nach dem Oberbegriff des Anspruches 1.

Die auf diesem Gebiete bekannte Technik besteht darin, daß magnetische Bereiche (Domänen) manipuliert und optisch abgetastet werden (siehe z. B. den Übersichtsartikel « Magnetic Bubbles — An Emerging New Memory Technology », A. H. Bobeck et al., Proceedings of the IEEE, Vol. 63, N° 8, August 1975, Seiten 1176 bis 1195, insbesondere Seiten 1176 bis 1179, oder « Domain Behavior in Some Transparent Magnetic Oxides », R. C. Sherwood et al. Journal of Applied Physics, Vol. 30, N° 2, February 1959, Seiten 217 bis 225). Ferner ist es aus der DE-A1-3 019 030 bekannt, mittels optischer (lichtleitender) Fasern Magnetfelder zu messen, wobei von dem Prinzip Gebrauch gemacht wird, daß das im optischen Modulator des Gebers verwendete Material eine Absorptionskante hat, die sich in Abhängigkeit der Größe des zu messenden magnetischen oder elektrischen Feldes verschiebt. Mit keiner der genannten Techniken ist es möglich, mittels optischer Fasern kleine magnetische Feldstärken mit großer Genauigkeit zu messen.

Der vorliegenden Erfindung liegt die Aufgabe zugrunde, eine Meßanordnung der eingangs genannten Art zu entwickeln, mit der kleine magnetische Feldstärken mit großer Genauigkeit gemessen werden können.

Zur Lösung dieser Aufgabe wird eine faseroptische Meßanordnung gemäß dem Oberbegriff des Anspruches 1 vorgeschlagen, die erfindungsgemäß die im kennzeichnenden Teil des Anspruches 1 genannten Merkmale hat.

Vorteilhafte Ausgestaltungen der Erfindung sind in den abhängigen Ansprüchen genannt.

Durch eine faseroptische Geberstruktur, die einen magnetooptischen Modulator des Bereichstyps enthält, der auf beiden Seiten mit optischen Filtern versehen ist, vorzugsweise mit Interferenzfiltern, können durch die optische Faser sehr kleine Veränderungen in dem Bild der magnetischen Bereiche mit großer Reproduzierbarkeit erfaßt werden.

Anhand der Figuren soll die Erfindung näher erläutert werden. Es zeigen

Figur 1 ein Ausführungsbeispiel einer faseroptischen Meßanordnung gemäß der Erfindung zur Messung magnetischer Felder,

Figur 2 die zum Geber gehörenden Bauteile in genauerer Darstellung,

Figur 3 Spektralkurven zur Erläuterung der Arbeitsweise der Meßanordnung nach der Erfindung,

Figur 4 eine Darstellung zur Erläuterung der Veränderung des Lichtes im Strahlengang des Gebers,

Figur 5 eine weitere Darstellung von Spektralkurven,

Figur 6 die Transmissionscharakteristik eines Filters,

Figur 7 ein Spektralkurvendiagramm zur Erläuterung einer weiteren Ausführungsform gemäß der Erfindung,

Figur 8 die Erzeugung eines Magnetfeldes durch einen stromdurchflossenen Leiter in einem Ringkern,

Figur 9 die Erzeugung eines Magnetfeldes im Geber durch eine stromdurchflossene Spule,

Figur 10 ein Ausführungsbeispiel für die Messung einer mechanischen Lage durch eine Meßanordnung gemäß Fig. 1,

Figur 11 die Integration eines Stromkreises mit einem Sensor gemäß Fig. 2,

Figur 12a eine andere Ausführungsform der Integrierung eines bzw. mehrerer Stromkreise mit einem Sensor gemäß Figur 2,

Figur 12b eine Darstellung zum Aufzeigen des Verlaufes der Feldstärke und des magnetischen Feldes in einer Anordnung nach Fig. 12a.

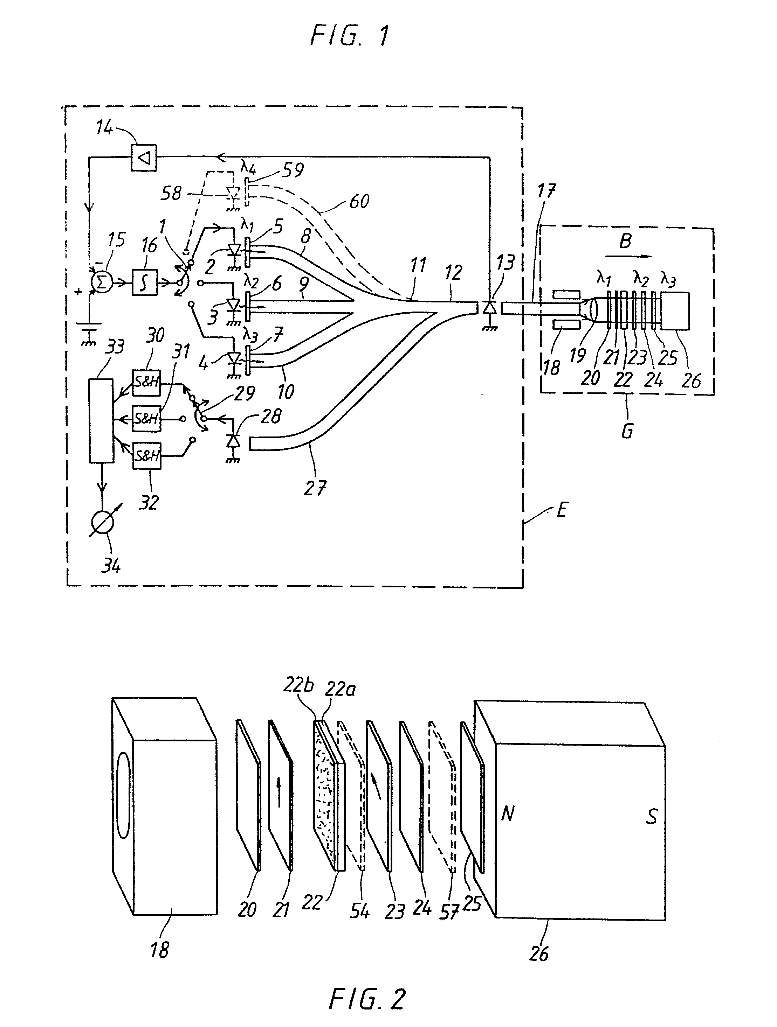

Figur 1 zeigt eine faseroptische Meßanordnung zur Messung eines magnetischen Feldes B. Der Schalter 1 schaltet der Reihe nach die Leucht- oder Laserdioden 2, 3, 4 ein, die Licht mit der Zentrumwellenlänge $\lambda_1$, $\lambda_2$ bzw. $\lambda_3$ emittieren. Damit sich die Emissionsspektren der Lichtquellen nicht gegenseitig überlappen, ist ein optisches Filter 5, 6 bzw. 7 zwischen jeder Lichtquelle und der optischen Faser 8, 9 bzw. 10, in die Licht hineingestrahlt wird, angeordnet. Über die opti-schen Verzweigungen 11 und 12 wird das Licht zu dem transparenten Fotodetektor 13 geleitet, dessen Ausgangssignal im Verstärker 14 verstärkt und über das Summierungsglied 15 und den Regler 16 zur Regelung der Lichtintensität der Lichtquellen 1-3 dient. Das Licht, das den transparenten Fotodetektor 13 passiert, wird von der optischen Faser 17 zum Geber G geleitet, der aus einem Feldkonzentrator 18, einer Linse 19, zwei Interferenzfiltern 20 und 24, zwei Polarisatoren (Polarisationsfilter) 21 und 23, einem magnetooptischen Modulator 22, einem Lichtabsorber 25 sowie einem Dauermagnet 26 besteht. Das von den Interferenzfiltern 20 und 24 in die Faser 17 zurückreflektierte Licht wird über die Verzweigung 12 und die Faser 27 zum Fotodetektor 28 geleitet. Das Signal des Detektors 28 wird vom Schalter 29 der Reihe nach über nicht besonders dargestellte Verstärker Folge- und Haltegliedern (S & H Gliedern) 30, 31 und 32 zur Speicherung der Intensitätswerte des Lichtes zugeführt, welches den Detektor 28 erreichen, wenn die Lichtquellen 2, 3 bzw. 7 eingeschaltet sind. Die Ausgangssignale der S & H-Glieder 30-32 werden einem Prozessor 33 zugeführt, der aus diesen Signalen de Meßwert berechnet, der durch das Anzeigegerät 34 angezeigt wird. Ein « Folge- und Halteglied » ist ein Glied, welches den einmal an seinem Eingang vorhanden gewesen Wert speichert und als Ausgangsgröße abgibt. Sobald ein neuer Eingangswert erscheint, wird dieser statt des bisherigen Wertes gespeichert und am Ausgang abgegeben.

Die zu dem Geber selbst gehörenden Bausteine werden — mit Ausnahme der Linse — in Fig. 2 genauer dargestellt. Der magnetooptische Modulator 22 besteht aus einem Substrat 22a, das mit einem dünnen Film aus ferromagnetischem Material 22b belegt ist, das so beschaffen ist, daß optische Bereiche (Domänen) auftreten. Als Beispiel für eine Klasse solchen Materials können Orthoferrite ($RFeO_3$) genannt werden, wobei R ein Metall der seltenen Erden sein kann. Es gibt eine Menge synthetischer Materialien mit der Eigenschaft, magnetisch anisotrop zu sein, so daß die Bereichsstrukturen in dünnen Schichten auftreten. Bei der Wahl von Material für Geberzwecke ist eine große Magnetorotation (Faraday-Effekt) — z. B. für $FeBO_3$ : $4 \cdot 10^3$ Grad/cm bei $\lambda$ = 0,5 $\mu$m ; für YIG : $1,5 \cdot 10^3$ Grad/cm bei $\lambda$ = 1,1 $\mu$m und für GdIG : $100^3$ Grad/cm bei $\lambda$ = 1,15 $\mu$m — bei den im Zusammenhang mit optischen Fasern normalerweise verwendeten Wellenlängen sowie eine nicht allzu hohe Lichtabsorption — $FeBO_3$ 100 cm$^{-1}$ bei $\lambda$ = 0,5 $\mu$m und YIG 7 cm$^{-1}$ bei $\lambda$ = 1,1 $\mu$m — erwünscht. Um eine möglichst kleine Temperaturabhängigkeit zu bekommen, darf das Material in dem Anderen Wellenlängenintervall keine Absorptionskante haben und gleichzeitig muß die Temperaturabhängigkeit der Faraday-Drehung minimal sein. Ferner ist das Material so zu wählen, daß die Temperaturabhängigkeit hinsichtlich der Größe der Bereiche bei aufgebrachtem äußeren Feld auf einem niedrigen Wert gehalten wird. Die resultierende Temperaturabhängigkeit des magnetooptischen Modulators kann durch Verwendung eines temperaturabhängigen Grundmagnetfeldes kompensiert werden, das man beispielsweise durch einen temperaturabhängigen Dauermagneten 26 erzeugen kann. Dieser kann z. B. aus dem Material Indox eingetragenes Warenzeichen hergestellt sein. Um ein genau definiertes Feld senkrecht zur Schicht 22b zu erhalten, ist auf der Faserseite des Gebers ein Feldkonzentrator 18 angeordnet.

Zum Erfassen der durch die Bereiche in der Schicht 22b erzeugten Faraday-Drehung sind zwei Polarisatoren 21 und 23 vorhanden. Diese sind derart zueinander gedreht, daß die Polarisationsdrehung, die durch den einen Bereich (in einer Richtung magnetisiert) verursacht wird, eine kleine Lichttransmission bewirkt, während der andere Bereich (in der entgegengesetzten Richtung magnetisiert) eine große Lichttransmission bewirkt. Wenn die eine Bereichsart infolge eines sich ändernden äußeren Magnetfeldes auf Kosten der anderen wächst, so wird folglich die Lichttransmission durch das optische System 21, 22 und 23 verändert.

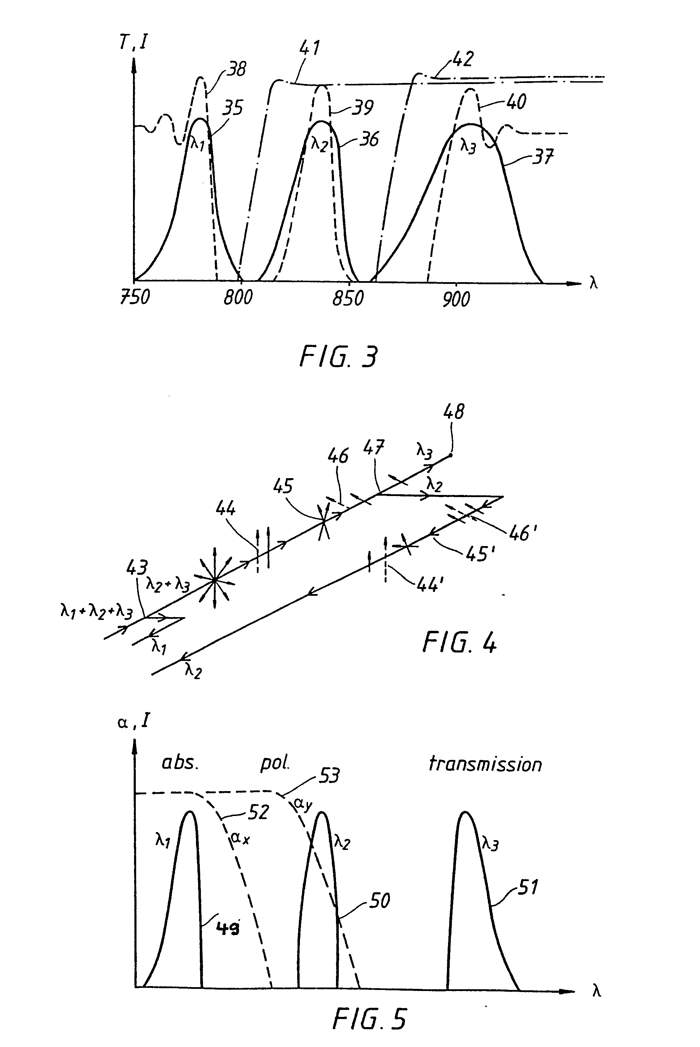

Um diese Veränderung der Lichttransmission mit hoher Genauigkeit über die optische Faser 17 erfassen zu können, wird eine Wellenlängenmultiplexierung benutzt, die in den Interferenzfiltern 20 und 24 durchgeführt wird. Die optische Meßtechnik, auf die sich dieser Vorgang gründet, kann mit Hilfe der Spektralkurven in Figur 3 beschrieben werden. Die drei Lichtquellen 2, 3 und 4 strahlen Licht mit den Spektren 35, 36 bzw. 37 aus. Die Filter 5, 6 und 7 garantieren mit ihren Transmissionsspektren 38, 39 bzw. 40, daß das in den verschiedenen Wellenlängenbereichen ($\lambda_1$, $\lambda_2$, $\lambda_3$) der Faseroptik zugeführte Licht keine sich gegenseitig überlappenden Spektren hat. Mit Hilfe der transparenten Fotodiode 13 wird sichergestellt, daß die Lichtenergiewerte in den einzelnen Wellenlängenbereichen in einem konstanten Verhältnis zueinander gehalten werden. Das Interferenzfilter 20 im Geber mit der Transmissionskurve 41 reflektiert das Licht im Wellenlängenbereich $\lambda_1$, was zur Kompensation einer variierenden Faserdämpfung benutzt wird. Das Interferenzfilter 24 im Geber mit der Transmissionskurve 42 reflektiert das Licht in dem Wellenlängenbereich $\lambda_2$, was zur Berechnung der Lichttransmission durch die Schichten 21, 22 und 23 benutzt wird. Das im Wellenlängenbereich $\lambda_3$ liegende Licht wird durch das Interferenzfilter 24 transmittiert und von dem Lichtabsorber 25 absorbiert. Zu dem Detektor 28 gelangt somit nur solches Licht mit dem Wellenlängenbereich $\lambda_3$, welches von Reflexionen im Optiksystem herrührt. Das Licht in dem Wellenlängenbereich $\lambda_3$ wird also zur Kompensation von variierenden Reflexionen benutzt. In Figur 4 ist der Strahlengang im Geber zusammengefaßt. Das ankommende Licht mit den Wellenlängen $\lambda_1$, $\lambda_2$ und $\lambda_3$ wird vom Interferenzfilter 20 an der Stelle 43 in transmittiertes nichtpolarisiertes Licht mit den Wellenlängen $\lambda_2$ und $\lambda_3$ sowie in reflektiertes Licht mit der Wellenlänge $\lambda_1$ aufgeteilt. Im Polarisator 21 (an der Stelle 44) wird das Licht linearpolarisiert, und im magnetooptischen Material 22 wird die Polarisationsebene in zwei Richtungen (45) gedreht, was davon abhängt, welche Bereiche passiert worden sind. Wenn dieses Licht den Polarisator 23 an der Stelle 46 passiert, wird Licht mit der einen Polarisationsrichtung gelöscht, und im Interferenzfilter 24 an der Stelle 47 wird daher nur Licht mit der anderen Polarisationsrichtung reflektiert, welches den Polarisator 23 an der Stelle 46', das Interferenzfilter 24 an der Stelle 45' und den Polarisator 21 an der Stelle 44' erneut passiert und als Meßinformation zum Detektor 28 weitergeleitet wird. Das vom Interferenzfilter 24 an der Stelle 47 transmittierte Licht mit der Wellenlänge $\lambda_3$ wird vom Lichtabsorber 25 an der Stelle 48 absorbiert.

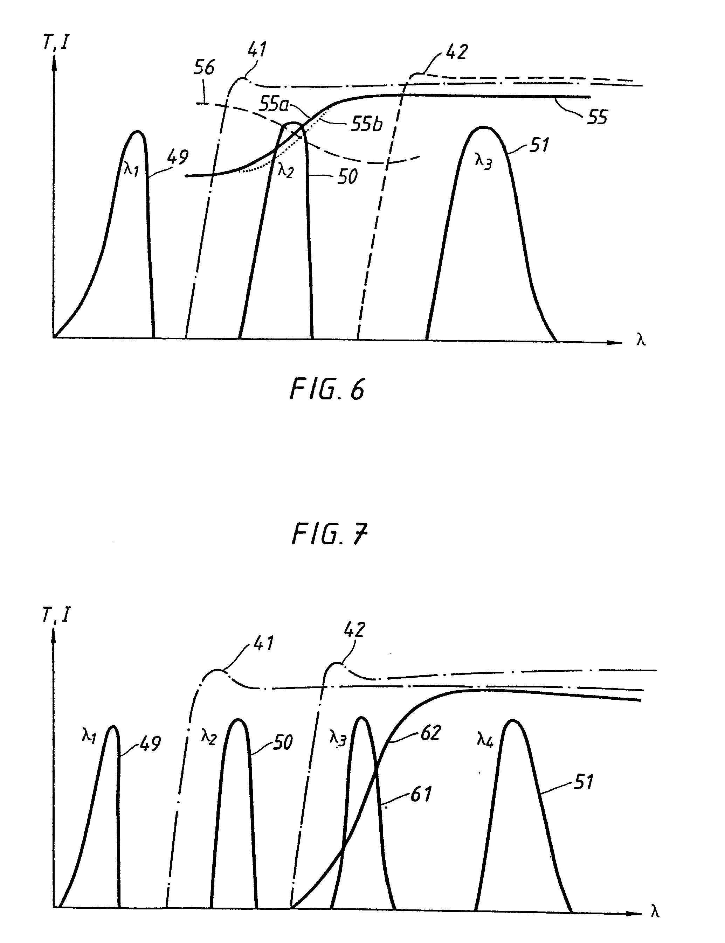

Wenn die polarisierenden Schichten 21 und 23 dichroitisch sind und wenn der Absorber 25 durch einen Reflektor ersetzt wird, kann auf die Interferenzfilter 20 und 24 verzichtet werden. Dies setzt jedoch voraus, daß eine Spektralcharakteristik gemäß Figur 5 verwendet wird. 49, 50 und 51 sind die Spektren für das zum Sensor gelangenden Lichtes. 52 ist das Absorptionsspektrum für die Polarisatoren 21 und 23 in einer Polarisationsrichtung x, und 53 ist das Absorptionsspektrum in einer anderen Polarisationsrichtung y. Gemäß Figur 5 wird das Licht mit der Wellenlänge $\lambda_1$ absorbiert. Es dient zur Kompensation von Reflexionen im Optiksystem. Licht

mit der Wellenlänge $\lambda_2$ wird polarisiert (zur Messung des Domänenzustandes) und Licht mit der Wellenlänge $\lambda_3$ wird transmittiert. Wenn der Lichtabsorber 25 durch einen Reflektor ersetzt wird, dann wird das Licht mit der Wellenlänge $\lambda_2$ reflektiert und zweimal von dem Polarisatorsystem beeinflußt, wie es anhand von Figur 4 beschrieben wurde. Das Licht mit der Wellenlänge $\lambda_3$ wird dagegen ohne Beeinflussung zurückreflektiert und kann dadurch zur Kompensation der Dämpfung im Optiksystem verwendet werden.

Zur Kompensation der Temperaturabhängigkeit des Sensors kann ein temperaturempfindliches Filter 54 an irgendeiner Stelle zwischen den Interferenzfiltern 20 und 24 in Figur 2 eingefügt werden. Figur 6 zeigt, wie die Transmissionskurve 55 dieses Filters so gewählt werden kann, daß man eine Absorptionskante im $\lambda_2$-Bereich erhält. Eine Erhöhung der Temperatur verschiebt diese Absorptionskante in Richtung größerer Wellenlängen, also von 55a nach 55b, wodurch das Licht im Wellenlängenbereich $\lambda_2$ in größerem Maße absorbiert wird. Dies kann direkt zur Kompensation einer infolge der Schichten 21, 22 und 23 mit der Temperatur zunehmenden Transmission verwendet werden. Wenn die Schichten 21-23 dagegen eine mit der Temperatur abnehmende Transmission haben, so kann ein Filter mit einer Absorptionskante 56 verwendet werden. Die Filter können mit verschiedenen Temperaturkoeffizienten durch zweckmäßige Wahl von Dicke und Material für Licht mit einem gegebenen Spektrum 50 « maßgeschneidert » werden.

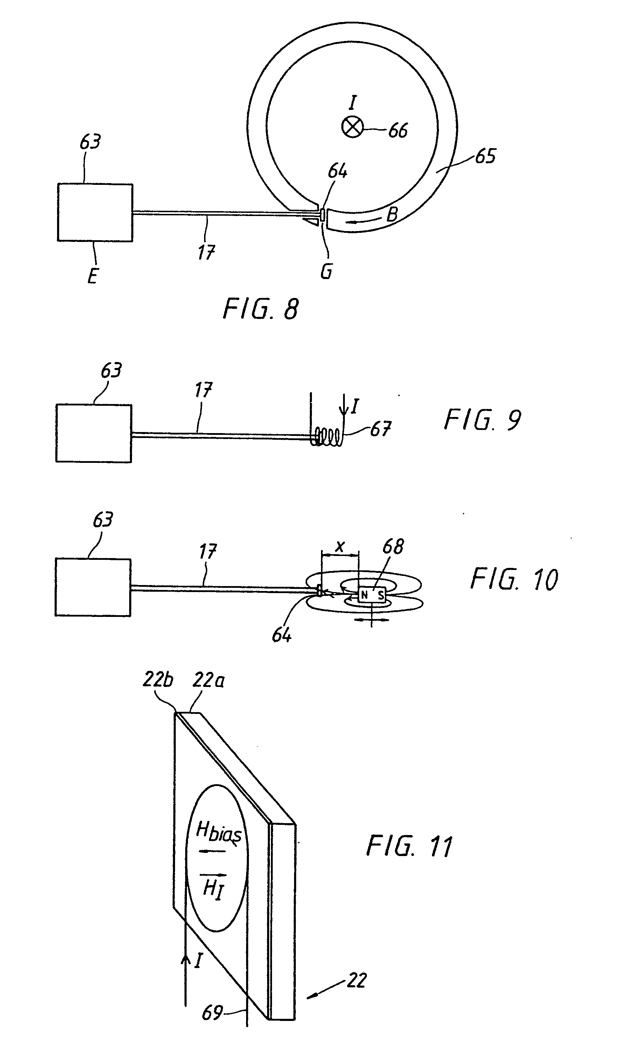

Statt der optischen Kompensation der Temperaturabhängigkeit des Gebers kann auch eine elektronische Kompensation durchgeführt werden, wobei die Gebertemperatur gemessen werden muß. Dies geschieht am einfachsten dadurch, daß eine weitere Lichtquelle 58 mit einem Filter 59 und einem Lichtleiter 60 in die Meßoptik (Figur 1) und ein weiteres optisches Filter 57 in den Geber eingesetzt wird. Den spektralen Zusammenhang einer solchen Anordnung zeigt Figur 7. 61 ist das Spektrum des Lichtes der Lichtquelle 58, nachdem das Licht das Filter 59 passiert hat, und 62 ist das Transmissionsspektrum des Filters 57. Wenn sich das Transmissionsspektrum 62 mit der Temperatur ändert, so erhält man eine temperaturabhängige Lichtintensität im Wellenlängenbereich $\lambda_3$. In der Berechnungseinheit 33 werden dann die folgenden Parameter extrahiert: die Dämpfung des Fasersystemes, die Reflexionen des Fasersystemes, die Temperatur des Gebers sowie die Größe des Magnetfeldes.

Zur Erfassung der optischen Bereiche wird bei den oben beschriebenen Ausführungsbeispielen der Faraday-Effekt in dem magnetischen Material benutzt. Eine alternative Technik zur Erfassung der Bereiche besteht darin, die Oberfläche der Schicht 22b mit einer Ferrofluidschicht zu belegen, wodurch die verschiedenen Magnetisierungsrichtungen der Bereiche die magnetischen Partikel im Ferrofluid derart orientieren, daß man in der Ferrofluidschicht eine von den Bereichen und den Bereichwänden abhängige Lichtdämpfung erhält. Zur Messung dieser Dämpfungsvariationen kann entweder nichtpolarisiertes oder polarisiertes Licht benutzt werden, wobei die Polarisatoren 21 und 23 beziehungsweise nur der Polarisator 23 überflüssig werden/wird.

Der Magnet 26 ist nicht erforderlich, wenn kein temperaturangepaßtes Ausgleichsmagnetfeld benötigt wird oder wenn keine Eigenschaften einer besonderen Art von Bereichen, wie z. B. Blasen, erforderlich sind. Wenn magnetische Blasenbereiche verwendet werden sollen, ist ein Grundfeld erforderlich, das größer ist als das Feld, das notwendig ist, damit Streifenbereiche in Blasenbereiche zerfallen können, das jedoch kleiner ist als das für einen Blasenkollaps erforderliche Feld. Da das Blasenkollapsfeld mit zunehmender Temperatur kleiner wird, muß auch das Ausgleichsfeld des Magneten 26 mit zunehmender Temperatur kleiner werden, was durch geeignete Wahl des Dauermagnetmaterials (Indox) erreicht werden kann. Einer der Vorteile der Arbeit mit Bereichen der Blasenart ist eine kleinere Hysterese und eine größere relative Transmissionsänderung. Wenn die Polarisatoren 21 und 23 so gedreht werden, daß alles Licht gelöscht wird, das durch diejenigen Teile des magnetischen Dünnfilms 22b tritt, die keine Blasen sind, so ist das optische Signal hinter dem Polarisator 23 proportional $D^2 \sin^2\Theta$, wobei D der Durchmesser der Blasen und $\Theta$ der Winkel zwischen der Polarisationsrichtung des Lichtes, das die Blasen passiert hat, und der Polarisationsrichtung des Polarisators 23 ist. In beispielsweise $Y_{1,4}Gd_{0,6}Bi\text{-}Fe_{3,8}Ga_{1,2}O_{12}$ kann die Lichttransmission durch das System aus den Gliedern 21, 22 und 23 für eine Änderung des externen Magnetfeldes außerhalb des Gebers zwischen 0 und 20 Oe (Oersted) um den Faktor 5 verändert werden., vorausgesetzt, daß man ein Grundfeld von 60 Oe hat.

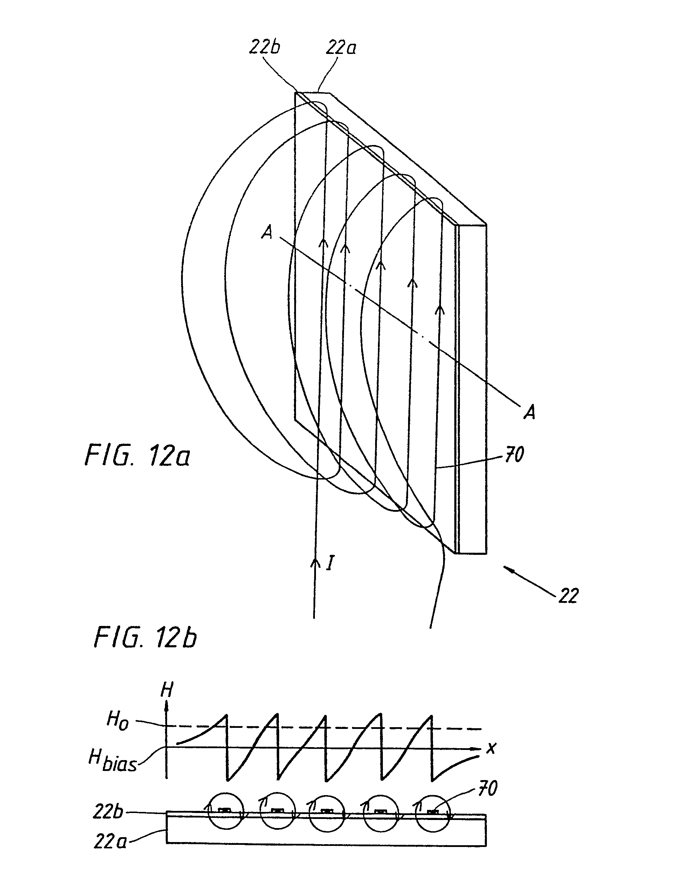

Wenn das Magnetfeld B von einem Strom I erzeugt wird, kann die Meßanordnung nach Figur 1 auch zur Strommessung verwendet werden. Figur 8 zeigt die Erzeugung eines Magnetfeldes B in einem Ringkern 65, der einen stromduichflossenen Leiter 66 umgibt. Zur Unterbringung des Magnetfeldgebers 64 ist in dem Ringkern 65 ein Luftspalt vorgesehen. Die optische Faser 17 verbindet den Magnetfeldgeber 64 mit der Meßelektronik E, die in Figur 8 das Bezugszeichen 63 hat. Zur Einführung der optischen Faser 17 in den Luftspalt ist im Ringkern 65 ein im wesentlichen tangential gerichtetes Loch vorhanden. Selbstverständlich kann auch eine stromdurchflossene Spule zur Erzeugung des Magnetfeldes im Geber verwendet werden, was in Figur 9 gezeigt ist. Statt das Magnetfeld durch einen äußeren Stromkreis zu erzeugen, wie es die Figuren 8 und 9 zeigen, kann dieses durch einen oder mehrere Stromkreise geschehen, die in die Sensorstruktur gemäß Figur 2 integriert sind. Wie dies geschehen kann, zeigen die Figuren 11 und 12. In Figur 11 liegt eine Stromschleife 69 in derselben Ebene wie der magnetooptische Modulator 22, wobei der Strom I ein Feld $H_I$ erzeugt, das zu dem vom Grundfeldmagneten 26 erzeugten Feld $H_{bias}$ addiert oder von diesem subtrahiert wird, was von der Richtung desselben abhängt. Der Strom I kann auch zur Positionierung der Bereiche in der Schicht 22b benutzt werden, indem man gemäß Figur 12 direkt auf dem Modulator 22 einen elektrischen Leiter 70 nach einem bestimmten Muster anordnet. In Figur 12 sind mehrere parallel zueinander verlaufende Strompfade gelegt, durch die ein Strom I in derselben Richtung geleitet wird. Hierdurch entsteht eine Magnetfeldverteilung entsprechend Figur 12b, was eine genau definierte Abhängigkeit zwischen dem Strom I und der Größe der Bereiche ergibt. Indem man die Anordnung der Leitungsbahnen den Übertragungsfunktionen des Optiksystems « maßgerecht » anpaßt, kann man zwischen I und dem Detektorlicht einen linearen Zusammenhang erzielen.

Es soll noch erwähnt werden, daß es möglich ist, mechanische Größen mit der Meßanordnung nach Figur 1 zu messen, wofür Figur 10 ein Beispiel zeigt, bei dem die Stärke des Magnetfeldes am Sensor 64 von dem Abstand X zwischen Sensor und Dauermagnet 68 abhängt.

**Patentansprüche**

1. Faseroptische Meßanordnung zur Messung eines Magnetfeldes, eines elektrischen Stromes und mechanischer Größen, wie beispielsweise einer Lage, bestehend aus einem Geber (G), der über mindestens eine optische Faser (17) mit einer Meßelektronik (E) verbunden ist, wobei der Geber (G) einen magnetooptischen Modulator (22) mit einem bereichbildenden magnetischen Material (22b) enthält, dadurch gekennzeichnet, daß der Geber (G) mindestens zwei optische Filter enthält, von denen mindestens ein Filter (20 und/oder 21) im Strahlengang auf der einen Seite des magnetooptischen Modulators (22) und mindestens ein anderes Filter (24 und/oder 23) im Strahlengang auf der gegenüberliegenden Seite des Modulators (22) plaziert ist, daß die Meßelektronik (E) mindestens drei Lichtquellen (2-4) mit verschiedenen Emissionsspektren ($\lambda_3$, $\lambda_2$, $\lambda_1$) enthält, die im Verhältnis zu den Filtern im Geber (G) so gewählt sind, daß das Licht von einer der Lichtquellen (2, 3, 4) in stärkerem Maße im Geber (G) absorbiert wird als das Licht der übrigen Lichtquellen, daß das Licht dieser übrigen Lichtquellen vom Geber (G) reflektiert wird, daß der magnetooptische Modulator (22) das Licht einer dieser übrigen Lichtquellen in stärkerem Maße moduliert als das Licht der anderen, und daß die Meßelektronik (E) eine Berechnungseinheit (33) enthält, die aus dem Signal eines Detektors (28), der optisch mit dem Lichtleiter (17) verbunden ist, den magnetooptischen Modulationsgrad unter Kompensation der variierenden Dämpfung und der Reflexionen des Lichtes im faseroptischen System berechnet.

2. Faseroptische Meßanordnung nach Anspruch 1, dadurch gekennzeichnet, daß der Geber (G) zur Kompensation der Temperaturabhängigkeit des optischen Modulators (22) ein im Strahlengang angeordnetes Filter (54) enthält, das eine temperaturabhängig Dämpfung für Licht in einem der Wellenlängenbereiche (50 oder 61 Fig. 6) der Lichtquellen hat.

3. Faseroptische Meßanordnung nach Anspruch 2 dadurch gekennzeichnet, daß das genannte Filter (54) mit temperaturabhängiger Dämpfung eine Absorptionskante (55a ; 55b ; 56) in dem genannten Wellenlängenbereich ($\lambda_3$) hat und daß die Temperaturabhängigkeit durch die temperaturabhängig Wellenlängenlage der genannten Absorptionskante zustandekommt (Fig. 6).

4. Faseroptische Meßanordnung nach Anspruch 2, dadurch gekennzeichnet, daß eine vierte Lichtquelle (58) mit einem von den Emissionsspektren der anderen Lichtquellen unterschiedlichen Emissionsspektrum (61) zum Erfassen der Temperatur des Gebers (G) vorhanden ist und daß das Filter (56) eine solche temperaturabhängige Dämpfung hat und derart im Geber (G) plaziert ist, daß das aus dem Geber (G) austretende Licht in dem Wellenlängenbereich der vierten Lichtquelle (58) eine größere Temperaturabhängigkeit hat als das Licht in den anderen Wellenlängenbereichen.

5. Faseroptische Meßanordnung nach einem der vorhergehenden Ansprüche, dadurch gekennzeichnet, daß mindestens eines der genannten Filter (20, 21, 23/24) ein Interfrenzfilter (20 bzw. 24) ist, und/oder daß mindestens zwei der genannten Filter dichroitische Polarisatoren (21, 23) sind.

6. Faseroptische Meßanordnung nach einem der vorhergehenden Ansprüche, dadurch gekennzeichnet, daß die Lichtquellen Leucht- und/oder Laserdioden sind, wobei zur Gewinnung des Lichtes in verschiedenen Wellenlängenbereichen Halbleiterdioden mit unterschiedlichen Bandabständen in der lichtemittierenden Halbleiterschicht und Interferenzfilter (59, 5-7) zwischen den Lichtquellen (58, 2-4) und dem faseroptischen System (60, 8-10) vorgesehen sind.

7. Faseroptische Meßanordnung nach einem der vorhergehenden Ansprüche, dadurch gekennzeichnet, daß zur Kompensation von Lichtstärkenunterschieden zwischen den Lichtquellen das Licht der Lichtquellen gemessen wird, bevor es zum Geber (G) gelangt.

8. Faseroptische Meßanordnung nach Anspruch 7, dadurch gekennzeichnet, daß die Messung mit einer im Strahlengang des Lichtleiters (17) liegenden transparenten Fotodiode (13) oder mit einem konventionellen Fotodetektor erfolgt, der Licht erfaßt, welches mittels Strahlenteiler und Verzweigung aus dem Lichtleiter (17) auskoppelbar ist.

9. Faseroptische Meßanordnung nach einem der vorhergehenden Ansprüche, dadurch gekennzeichnet, daß der magnetooptische Modulator (22) eine anisotrope magnetische Schicht (22b) mit ausgebildeten magnetischen Bereichen enthält, daß diese Bereiche in zwei alternativen Richtungen magnetisiert sind, und zwar entweder aus der Schicht heraus oder in die Schicht hinein, daß das magnetische Feld eine Komponente quer zur Schicht hat und daß Größenveränderungen dieser Magnetfeldskomponente variierende Größenverhältnisse zwischen den magnetischen Bereichen verursachen, die parallel bzw. antiparallel zu der genannten Magnetfeldskomponente magnetisiert sind.

10. Faseroptische Meßanordnung nach Anspruch 9, dadurch gekennzeichnet, daß die variierenden Größenverhältnisse zwischen den magnetischen Bereichen mit im Verhältnis zu dem äußeren Feld paralleler bzw. antiparalleler Magnetisierung optisch durch zwei Lichtpolarisatoren (21, 23) abgetastet werden, die auf je einer Seite des magnetooptischen Modulators (22) im Strahlengang plaziert sind, und daß die Polarisationsrichtungen der Polarisatoren (21, 23) zur Erfassung der durch die magnetischen Bereiche verursachten Drehung der Polarisationsrichtung des Lichtes durch den Faraday-Effekt im Verhältnis zueinander gedreht sind.

11. Faseroptische Meßanordnung nach einem der vorhergehenden Ansprüche, dadurch gekennzeichnet, daß mindestens ein Dauermagnet (26) im Geber (G) vorhanden ist, der ein Grundmagnetfeld senkrecht zur Oberfläche des magnetooptischen Modulators (22) erzeugt.

12. Faseroptische Meßanordnung nach einem der vorhergehenden Ansprüche, dadurch gekennzeichnet, daß der magnetische Modulator (22) in einem Luftspalt eines aus ferromagnetischem Material bestehenden Ringes (65) angeordnet ist, durch den mindestens ein elektrischen Strom führender Leiter (66) verläuft (Fig. 8).

13. Faseroptische Meßanordnung nach einem der Ansprüche 1-11, dadurch gekennzeichnet, daß eine Stromschleife (69) derart auf der Oberfläche des Modulators (22) angeordnet ist, daß das vom Spulenstrom erzeugte Magnetfeld senkrecht zur Modulatorschicht (22b) ein optisch erfaßbares Signal gibt (Fig. 11).

14. Faseroptische Meßanordnung nach einem der Ansprüche 1 bis 11, dadurch gekennzeichnet, daß elektrische Leiter (70) derart auf der Oberfläche des magnetischen Modulators (22) angeordnet sind, daß die von einem die Leiter durchfließenden Strom erzeugte Feldverteilung die magnetischen und optischen Eigenschaften des Modulators (22) beeinflußt (Fig. 12a).

15. Faseroptische Meßanordnung nach einem der vorhergehenden Ansprüche, dadurch gekennzeichnet, daß der magnetooptische Modulator (22) von einem oder mehreren in Raum beweglich angeordneten Dauermagneten (68) beeinfluß wird.

16. Faseroptische Meßanordnung nach einem der vorhergehenden Ansprüch, dadurch gekennzeichnet, daß die Oberfläche des magnetischen Modulators (22b) mit einer Schicht eines Ferrofluids belegt ist.

**Claims**

1. Fiber-optical measuring device for the measurement of a magnetic field, an electric current, and mechanical magnitudes as for example a position, consisting of a transducer (G), being connected at least via one optical fiber (17) to a measuring electronic unit (E), the transducer (G) comprising a magneto-optical modulator (22) with a domain-producing magnetic material (22b), characterized in that the transducer (G) comprises at least two optical filters, at least one of these filters (20 and/or 21) is located in the ray path on one side of said magneto-optical modulator (22) and at least one other filter (24 and/or 23) is located in the ray path on the opposite side of the modulator (22), that said measuring electronic unit (E) comprises at least three light sources (2, 3, 4) with different emission spectra $(\lambda_1, \lambda_2, \lambda_3)$, which are chosen with respect to the filters in the transducer (G) such that the light from one of said light sources (2, 3, 4) is absorbed in said transducer (G) to a greater degree than the light from the remaining light sources, that the light of said remaining light sources is reflected from the transducer (G), that the magneto-optical modulator (22) modulates the light from one of said remaining light sources to a greater degree than the light from the other light sources, and that the measuring electronic unit (E) includes a calculating unit (33) for calculating, from the signal of a detector (28) being optically connected to said optical fiber (17), the magneto-optical degree of modulation with compensation of the varying attenuation and reflections of the light in the fiber-optical system.

2. Fiber-optical measuring device according to claim 1, characterized in that the transducer (G), in order to compensate for the temperature dependence of the optical modulator (22), comprises a filter (54) mounted in the ray path, which filter (54) has a temperature-dependent attenuation for the light within one of the wave ranges (50 or 61 ; Figure 6) of the light sources.

3. Fiber-optical measuring device according to claim 2, characterized in that said filter (54) with a temperature-dependent attenuation has an absorption edge (55a ; 55b ; 56) within said wave range $(\lambda_3)$, and that the temperature-dependence is obtained by the temperature-dependent wave length position of said absorption edge (Figure 6).

4. Fiber-optical measuring device according to claim 2, characterized in that a fourth light source (58) with in emission spectrum (61) different from the emission spectra of the other light sources is provided for sensing the temperature of said transducer (G), and that the filter (56) has such a temperature-dependent attenuation and is located in the transducer (G) in such way that the light emanating from the transducer (G) has a greater temperature dependence in the wave range of the fourth light source (58) than the light in the other wave ranges.

5. Fiber-optical measuring device according to any of the preceding claims, characterized in that at least one of said filters (20, 21, 23/24) is of interference type (20, 24 respectively), and/or that at least two of said filters are dichroic polarizers (21, 23).

6. Fiber-optical measuring device according to any of the preceding claims, characterized in that said light sources are light-emitting and/or laser diodes, whereby for obtaining of light in different wave ranges semiconductor diodes with different band gaps in the light emitting semiconductor layer and interference filters (59, 5-7) between the light sources (58, 2-4) and the fiber-optical system (60, 8-10) are provided.

7. Fiber-optical measuring device according to any of the preceding claims, characterized in that for compensating for differences in luminous intensity between said light sources the light of said light sources is measured before reaching the transducer (G).

8. Fiber-optical measuring device according to claim 7, characterized in that the measurement is carried out with the help of a transparent photo-diode (13) positioned in the ray path of the optical fiber (17) or with the help of a conventional photodetector sensing light, coupled out from said optical fiber (17) by a beam splitter and a branch.

9. Fiber-optical measuring device according to any of the preceding claims, characterized in that said magneto-optical modulator (22) comprises an anisotropic magnetic layer (22b) with formed magnetic domains, that said domains are capable of being magnetized in two alternative directions, namely either out from said layer or into said layer, that the magnetic field has a component perpendicular to the layer and that variations in magnitude of this magnetic field component causes different magnitude relationships between the magnetic domains which are capable of being magnetized in parallel and in anti-parallel, respectively, with said magnetic field component.

10. Fiber-optical measuring device according to claim 9, characterized in that the varying magnitude relationships between said magnetic domains having a magnetization parallel and anti-parallel, respectively to the external field are optically sensed by two light polarizers (21, 23), which polarizers are positioned in the ray path each on one side of the magneto-optical modulator (22), and that the directions of polarisation of the polarizers (21, 23) are rotated with respect to each other for detecting of the rotation of the polarization directions of the light, caused by the magnetic domains through the Faraday effect.

11. Fiber-optical measuring device according to any of the preceding claims, characterized in that the transducer (G) includes at least one permanent magnet (26), generating a bias magnetic field perpendicular to the surface of the magneto-optical modulator (22).

12. Fiber-optical measuring device according to any of the preceding claims, characterized in that the magneto-optical modulator (22) is located within the air gap of a ring (65), which consist of ferro-magnetic material and through which extends at least one conductor (66) carrying in electric current (Figure 8).

13. Fiber-optical measuring device according to any of claim 1 to 11, characterized in that in electric coil (69) is arranged on the surface of the modulator (22) in such a way that the magnetic field generated by the current through the coil and being directed perpendicular to the modulator layer (22b) produces in optical detectable signal (Figure 11).

14. Fiber-optical measuring device according to any of claim 2 to 11, characterized in that the electric conductors (70) are arranged on the surface of the magnetic modulator (22) in such a way that the field distribution generated by a current flowing through said conductor influences the magnetic and optical properties of the modulator (22) (Figure 12a).

15. Fiber-optical measuring device according to any of the preceding claims, characterized in that the magnetic modulator (22) is influenced by one or several permanent magnets (68) mounted movably in the surrounding space.

16. Fiber-optical measuring device according to any of the preceding claims, characterized in that the surface of the magnetic modulator (22b) is provided with a layer of a ferro-fluid.

**Revendications**

1. Dispositif de mesure à fibres optiques pour mesurer un champ magnétique, un courant électrique et des grandeurs mécaniques, comme par exemple une position, constitué par un capteur de valeurs de mesure (G) qui est relié, par l'intermédiaire d'au moins une fibre optique (17), à une électronique de mesure (E), ledit capteur (G) comportant un modulateur magnétooptique (22) avec un matériau magnétique (22b) formateur de plages, caractérisé par le fait que le capteur (G) comporte au moins deux filtres optiques dont au moins un filtre (20 et/ou 21) est placé dans la trajectoire des rayons sur un côté du modulateur magnéto-optique (22) et au moins un autre filtre (24 et/ou 23) dans la trajectoire des rayons sur le côté opposé du modulateur, que l'électronique de mesure (E) comporte au moins trois sources lumineuses (2-4) ayant des spectres d'émission différents ($\lambda_1$, $\lambda_2$, $\lambda_3$) qui, en rapport aux filtres prévus dans le capteur (G), sont choisis de telle manière que la lumière provenant de l'une des sources lumineuses (2, 3, 4) est absorbée dans le capteur (G) dans une mesure plus importante que ne l'est la lumière des autres sources lumineuses, que la lumière issue de ces dits autres sources lumineuses est réfléchie par le capteur (G), que le modulateur magnéto-optique (22) module la lumière de l'une de ces autres sources lumineuses à un degré plus important que la lumière des autres, et que l'électronique de mesure (E) comporte une unité de calcul (33) qui calcule, à partir du signal d'un détecteur (28) qui est relié optiquement au guide d'ondes de lumière (17), le degré de modulation magnéto-optique, avec compensation de l'atténuation et de réflexions variables de la lumière dans le système à fibres optiques.

2. Dispositif de mesure à fibres optiques selon la revendication 1, caractérisé par le fait que le capteur (G) comporte, pour la compensation de la dépendance par rapport à la température du modulateur optique (22), un filtre (54) disposé dans la trajectoire des rayons, possédant une atténuation, en fonction de la température, pour une lumière qui se situe dans l'une des plages (50 ou 61 figure 6) des longueurs d'ondes des sources lumineuses.

3. Dispositif de mesure à fibres optiques selon la revendication 2, caractérisé par le fait que ledit filtre (54) à atténuation en fonction de la température, possède une arrête d'absorption (55a ; 55b ; 56) dans ladite plage des longueurs d'onde ($\lambda_3$) et que la dépendance en fonction de la température provient de la position, dépendant de la température, de la longueur d'onde, de ladite arrête d'absorption (figure 6).

4. Dispositif de mesure à fibres optiques selon la revendication 2, caractérisé par le fait qu'une quatrième source lumineuse (58) possédant un spectre d'émission (61) qui est différent du spectre d'émission des autres sources lumineuses, est prévue pour saisir la température du capteur (G) et que le filtre (56) possède une atténuation telle, en fonction de la température et est placé de telle façon dans le capteur (G), que la lumière issue du capteur possède dans la plage de longueur d'onde de la quatrième source lumineuse (58), une dépendance en fonction de la température qui est plus importante que la lumière dans les autres plages de longueurs d'ondes.

5. Dispositif de mesure à fibres optiques selon l'une des revendications précédentes, caractérisé par le fait qu'au moins l'un desdits filtres (20, 21, 23/24) est un filtre interférentiel (20, 24) et/ou au moins deux desdits filtres sont des polariseurs dichroïques (21, 23).

6. Dispositif de mesure à fibres optiques selon l'une des revendications précédentes, caractérisé par le fait que les sources lumineuses sont des diodes luminescentes et/ou des diodes laser, étant noté que pour obtenir la lumière dans des plages de longueurs d'ondes différentes, on prévoit des diodes à semi-conducteurs à écarts de bandes différents dans la couche semi-conductrice à émission lumineuse et des filtres interférentiels (59, 5-7) entre les sources lumineuses (58, 2-4) et le système à fibres optiques (60, 8-10).

7. Dispositif de mesure à fibres optiques selon l'une des revendications précédentes, caractérisé par le fait que pour compenser les différences d'intensités lumineuses entre des sources lumineuses, on mesure la lumière des sources lumineuses, avant que la lumière n'atteigne le capteur (G).

8. Dispositif de mesure à fibres optiques selon la revendication 7, caractérisé par le fait que la mesure a lieu avec une photo-diode transparente (13) qui se situe dans la trajectoire des rayons du guide d'ondes de lumière (17), ou à l'aide d'un photo-détecteur conventionnel qui saisit de la lumière et qui est découplé à l'aide de diviseurs et de répartiteurs de lumière, à partir du guide d'ondes de lumière (17).

9. Dispositif de mesure à fibres optiques selon l'une des revendications précédentes, caractérisé par le fait que le modulateur magnéto-optique (22) comporte une couche magnétique anisotrope (22b) à plages magnétiques conformées, que ces plages sont magnétisées suivant deux directions alternées, et notamment soit en provenant de la couche ou en y pénétrant, que le champ magnétique possède une composante qui est transversale par rapport à la couche et que les variations des grandeurs de ces composantes du champ magnétique provoquent des rapports de grandeurs variables entre les zones magnétiques, qui sont aimantées parallèlement ou anti-parallèlement ou par rapport auxdites composantes du champ magnétique.

10. Dispositif de mesure à fibres optiques selon la revendication 9, caractérisé par le fait que les rapports de grandeurs variables entre les zones magnétiques à aimantation parallèle ou antiparallèle par rapport au champ extérieur, sont explorées optiquement par deux polariseurs de lumière (21, 23) qui sont respectivement disposés dans la trajectoire des rayons de part et d'autre du modulateur magnéto-optique, et que les directions de polarisation des polariseurs (21, 23) subissent entre eux une rotation par effet de Faraday, en vue de saisir la rotation du centre de polarisation de la lumière, causée par les zones magnétiques.

11. Dispositif de mesure à fibres optiques selon l'une des revendications précédentes, caractérisé par le fait qu'il est prévu dans le capteur (G) au moins un aimant permanent (26) qui produit un champ magnétique de base, perpendiculairement à la surface du modulateur magnéto-optique (22).

12. Dispositif de mesure à fibres optiques, selon l'une des revendications précédentes, caractérisé par le fait que le modulateur magnétique (22) est disposé dans l'entrefer d'un anneau (65) constitué par un matériau ferro-magnétique, et traversé par au moins un conducteur (66) parcouru par un courant électrique (figure 8).

13. Dispositif de mesure à fibres optiques selon l'une des revendications 1-11, caractérisé par le fait que sur la surface du modulateur (22) est disposée une boucle de courant (69) de telle manière que le champ magnétique produit par le courant de la bobine fournit, perpendiculairement à la couche du modulateur (22b) un signal qui est susceptible d'être saisi par voie optique (figure 11).

14. Dispositif de mesure à fibres optiques selon l'une des revendications 1-11, caractérisé par le fait que des conducteurs électriques (70) sont disposés de telle façon sur la surface du modulateur magnétique (22) que la répartition des champs, qui est produite par un courant qui passe par les conducteurs influence les propriétés magnétiques et optiques du modulateur (22) (figure 12a).

15. Dispositif de mesure à fibres optiques selon l'une des revendications précédentes, caractérisé par le fait que le modulateur magnéto-optique (22) est influencé par un ou par plusieurs aimants permanents (68) disposés de façon mobile dans l'espace.

16. Dispositif de mesure à fibres optiques selon l'une des revendications précédentes, caractérisé par le fait que la surface du modulateur magnétique (22b) est recouverte d'une couche d'un ferrofluide.

FIG. 1

FIG. 2

# 0 076 228

FIG. 3

FIG. 4

FIG. 5

0 076 228

FIG. 6

FIG. 7

FIG. 8

FIG. 9

FIG. 10

FIG. 11

FIG. 12a

FIG. 12b